# EUROPEAN PATENT SPECIFICATION

(11) **EP 1 511 370 B1**
(45) Date of publication and mention of the grant of the patent: **14.03.2007**
(21) Application number: 02808119.8
(22) Date of filing: 11.11.2002
(51) Int. Cl.: H05K 9/00, H01F 1/00, H01F 1/33, H01F 1/08, H01F 1/28

(54) **COUNTER EMI COMPONENT AND COUNTER EMI METHOD**
GEGEN-EMI-KOMPONENTE UND GEGEN-EMI-VERFAHREN
COMPOSANT CONTRE LES PARASITES ELECTROMAGNETIQUES ET PROCEDE CONTRE LES PARASITES ELECTROMAGNETIQUES

(43) Date of publication of application: 02.03.2005
(73) Proprietor: Nec Tokin Corporation, Sendai-shi, Miyagi 982-8510 (JP)
(72) Inventor: YOSHIDA, Shigeyoshi, Sendai-shi, Miyagi 982-8510 (JP); ONO, Hiroshi, Sendai-shi, Miyagi 982-8510 (JP); SATO, Mitsuharu, Sendai-shi, Miyagi 982-8510 (JP)
(74) Representative: Hofer, Dorothea
(86) International application number: PCT/JP2002/011737
(87) International publication number: WO 2004/045265

(56) References cited:
- EP-A- 0 871 183
- DE-A1- 2 533 900
- JP-A- 5 013 979
- JP-A- 9 312 489
- PATENT ABSTRACTS OF JAPAN vol. 017, no. 640 (E-1465), 26 November 1993 (1993-11-26) -& JP 05 206676 A (NEC CORP; others: 02), 13 August 1993 (1993-08-13)
- PATENT ABSTRACTS OF JAPAN vol. 1998, no. 04, 31 March 1998 (1998-03-31) -& JP 09 312489 A (TOKIN CORP), 2 December 1997 (1997-12-02)
- PATENT ABSTRACTS OF JAPAN vol. 1999, no. 10, 31 August 1999 (1999-08-31) -& JP 11 144960 A (MURATA MFG CO LTD), 28 May 1999 (1999-05-28)
- PATENT ABSTRACTS OF JAPAN vol. 017, no. 283 (E-1373), 31 May 1993 (1993-05-31) -& JP 05 013979 A (NEC CORP), 22 January 1993 (1993-01-22)
- PATENT ABSTRACTS OF JAPAN vol. 013, no. 393 (E-814), 31 August 1989 (1989-08-31) -& JP 01 138799 A (INAX CORP), 31 May 1989 (1989-05-31)
- YOSHIDA SHIGEYOSHI ET AL: "Permeability and electromagnetic-interference characteristics of Fe-Si-Al alloy flakes-polymer composite" JOURNAL OF APPLIED PHYSICS, AMERICAN INSTITUTE OF PHYSICS. NEW YORK, US, vol. 85, no. 8, 15 April 1999 (1999-04-15), pages 4636-4638, XP012047206 ISSN: 0021-8979

## Description

### Technical Field

The present invention relates to a component for suppressing EMI (electromagnetic interference) and a method for suppressing EMI in bus lines through which data is passed between data processors or between information-processing devices, such as personal computers having a CPU and an MPU, and input-output devices.

### Background Art

In general, noise is classified into radiated noise and conducted noise according to the method of propagation. With regard to radiated noise, EMI can be suppressed with metal shielding. Conducted noise is further classified into normal-mode noise and common-mode noise. In order to suppress normal-mode noise, measures has been taken which includes the steps of providing an inductor, a capacitor, and an EMI filter in a signal circuit. Common-mode noise is propagated through a ground line and is released into the air through an interface cable functioning as an antenna. Recently, since high-speed digital signals and high-frequency signals are often being used, measures against common-mode noise are gaining in importance.

Conventionally, measures are not usually taken against the common-mode noise. When some measures are required, various filters are placed in circuits. However, when a filter is provided in a circuit, part of the circuit must be cut away to form a space for the filter, and the filter is then connected to the circuit. This is very troublesome. In particular, in many cases signal circuits are arranged as a conductive pattern disposed on a circuit substrate. Therefore, once the conductive pattern is cut, it cannot be repaired. Recently, some space and lines for the filter are reserved in advance in the conductive pattern in consideration of the occurrence of noise. However, bus lines through which data is passed between data processors include lines which are very close together. Thus, it is very difficult to take measures against EMI.

Generally, expertise and experience in noise suppression are required in order to take measures against EMI and it takes a long time to take the measures. Moreover, there is a problem in that filters are expensive, the space for mounting the filters is limited in many cases, the work required to mount the filter is not easy, and the number of man-hours required to fabricate a device is increased, thus raising the manufacturing cost. In particular, it is useless that the space is reserved and the lines are provided in advance, if noise is not produced.

Recently, since all devices need to be small in size and thickness, it is very difficult to simultaneously take satisfactory measures against noise using conventional techniques and to achieve compact electronic devices.

From JP 05-206676 A an electromagnetic absorbing body can be taken which comprises a composite soft magnetic sheet and a permanent magnetic sheet, stacked to each other, wherein the composite magnetic sheet contains a soft magnetic powder formed by ferrite.

From JP 09-312489 A a composite magnetic layer can be taken.

From JP 11-144960 A a choke coil can be taken which has a soft magnetic core and a permanent magnetic layer disposed on the soft magnetic core, wherein the soft magnetic core is made of a spinel type ferrite.

From JP 05-013979 A an electromagnetic shielding body can be taken which comprises a conductive bar having a section of a C-shape, a permanent magnetic bar, and a soft magnetic bar, both of which are stacked to each other and contained in the conductive bar. The soft magnetic powder is made of ferrite and an organic binder.

From JP 01-138799 a thin layer electromagnetic wave absorbing body can be taken which comprises a soft ferrite plate and a permanent magnetic plate.

Accordingly, it is an object of the present invention to provide a component for suppressing EMI and a method of suppressing EMI, wherein the component has a dead space used for taking satisfactory measures against EMI if it turns out that noise is produced after necessary devices are mounted to form a circuit without taking measures against noise.

### Disclosure of the invention

The present invention has been made in order to take measures against common-mode noise radiated from interface cables functioning as an antenna and against high-frequency noise generated in recent devices using high-frequency signals. The present invention provides a component for suppressing EMI and a method of suppressing EMI in which the component is used. The component has high effectiveness improved by applying a bias magnetic field to a composite magnetic material, which has been developed by the inventors, for suppressing EMI.

That is, according to one aspect of the present invention, there is provided an EMI-suppressing component according to claim 1.

According to another aspect of the present invention, there is provided an EMI-suppressing method according to claim 10.

### Brief Description of the Drawing

Fig. 1 is a perspective view showing a configuration in which an EMI-suppressing component according to a first embodiment of the present invention is placed on a bus line connected to a CPU in order to suppress EMI, wherein the EMI-suppressing component is shown in a partly exploded manner.
Fig. 2 is a sectional view showing a configuration in which an EMI-suppressing component according to a second embodiment of the present invention is arranged at a position close to a bus line.
Fig. 3 is a sectional view showing a configuration in which an EMI-suppressing component according to a third embodiment of the present invention is arranged at a position close to the bus line.
Fig. 4 is a schematic view illustrating a testing apparatus for evaluating an EMI-suppressing component of the present invention and illustrating the function thereof.
Fig. 5 is a graph showing the reflection/transmission characteristic (S11), the permeation/transmission characteristic (S21), and the electrical loss factor (P(loss) / P(in)) of the sample with respect to the frequency at a bias magnetic field intensity of 0.
Fig. 6 is a graph showing the electrical loss factor of a sample to which different bias magnetic fields are applied.
Fig. 7 is an illustration showing a configuration in which a permanent magnet is placed on the sample instead of the Helmholtz coils, shown in Fig. 4, for applying a magnetic field.
Fig. 8 is a graph showing the electrical loss factor of the sample shown in Fig. 7.
Fig. 9 is a graph showing the relationship between the imaginary part µ"of the permeability and the frequency, and Fig. 10 is a graph showing the relationship between a frequency and a product of the imaginary part µ" of the permeability and the frequency, wherein the permeability is determined changing the intensity of a bias magnetic field applied to the sample.
Fig. 11 is a graph showing changes in the real part µ' and the imaginary part µ" of the permeability with respect to the frequency in such a case that a magnetic field is not applied.
Fig. 12 is a perspective view showing a configuration in which an EMI-suppressing component according to a fourth embodiment of the present invention is placed on a bus line in order to suppress EMI, wherein the EMI-suppressing component is shown in a partly exploded manner.

### Best Mode for Carrying Out the Invention

Embodiments of the present invention will now be described with reference to the accompanying drawings.

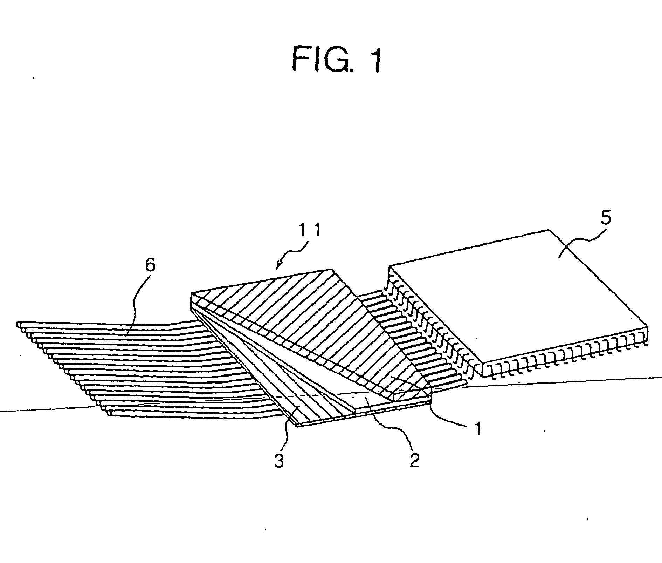

Fig. 1 is a perspective view showing a configuration in which an EMI-suppressing component 11 according to a first embodiment of the present invention is placed on a bus line 6 connected to a CPU 5 in order to suppress EMI. The EMI-suppressing component 11 is shown in a partly exploded manner. The bus line 6 connects the CPU 5 and external circuits, which are not shown.

In the first embodiment, the EMI-suppressing component 11 functioning as a device for suppressing electromagnetic interference has a composite magnetic material layer 1, which is sheet-shaped. The composite magnetic material layer 1 is a sheet containing an organic binder and metal magnetic powder that is dispersed in the organic binder and includes particles having an oxide coating. The composite magnetic material layer 1 has two different magnetic resonance frequencies. The composite magnetic material layer 1 includes a composite permanent magnet layer 2 on one face thereof. The composite permanent magnet layer 2 is made by dispersing SmCo₅ permanent magnet powder in a organic binder and ,then solidifying the mixture thereof. The composite permanent magnet layer 2 has a pressure sensitive adhesive layer 3 on one face other than one face on which the composite magnetic material layer is formed. The adhesive layer 3 contains polyvinyl alcohol as a main component.

The electromagnetic interference-suppressing device 11 is disposed over the bus line 6 for connecting the CPU 5 to external circuits, the adhesive layer 3 being located between the composite permanent magnet layer 2 and the line.

The first embodiment of the present invention will now be described in detail.

Table 1 shows the composition of the composite magnetic material containing soft magnetic material powder and the organic binder. The soft magnetic material powder is obtained by oxidizing Fe-Al-Si alloy powder in an oxygen-nitrogen gas atmosphere with an oxygen partial pressure of 20%. Thus, the powder particles are each covered with an oxide coating.

The composite permanent magnet layer 2 is prepared according to the following procedure: permanent magnet powder comprising SmCo₅ is dispersed in a binder comprising a polypropylene polymer and a sheet is then formed.

The composite magnetic material layer 1 is formed on the composite permanent magnet sheet 2 according to a procedure described below. Paste containing the mixture of materials shown in Table 1 described below is applied onto the composite permanent magnet sheet 2 with a squeegee, and the applied paste is sufficiently dried and then pressed to form a composite magnetic material sub-layer having a thickness of 0.1 mm. The above paste is applied onto the resulting composite magnetic material sub-layer, dried, and then pressed, repeatedly, to form a multilayer structure of composite magnetic material sub-layers. When the entire thickness reaches 1 mm, the multilayer structure is cured by heating treatment at 70°C for 48 hours to complete the composite magnetic material layer on the composite magnet sheet. The EMI-suppressing component sheet having the composite magnetic material layer and the composite permanent magnet layer disposed thereon is obtained by the above procedure. The composite magnetic material layer has a surface resistance of 1 × 10⁷ Ω.

The adhesive layer 3 is formed by applying an adhesive agent containing polyvinyl alcohol onto the back of a face on which the composite magnetic material layer is disposed.

**[Table 1]**

| Soft magnetic powder | | |
|---|---|---|
| Fe-Al-Si alloy | | 90 weight parts |
| | Average particle diameter: 10µm | |
| | Aspect ratio: >5 | |

| Organic binder | | |
|---|---|---|
| Polyurethane resin | | 8 weight parts |
| Isocyanate compound | | 2 weight parts |

| Solvent | | |
|---|---|---|
| Compound of cyclohexane and toluene | | 40 weight parts |
| Ethyl cellosolve | | 65 weight parts |

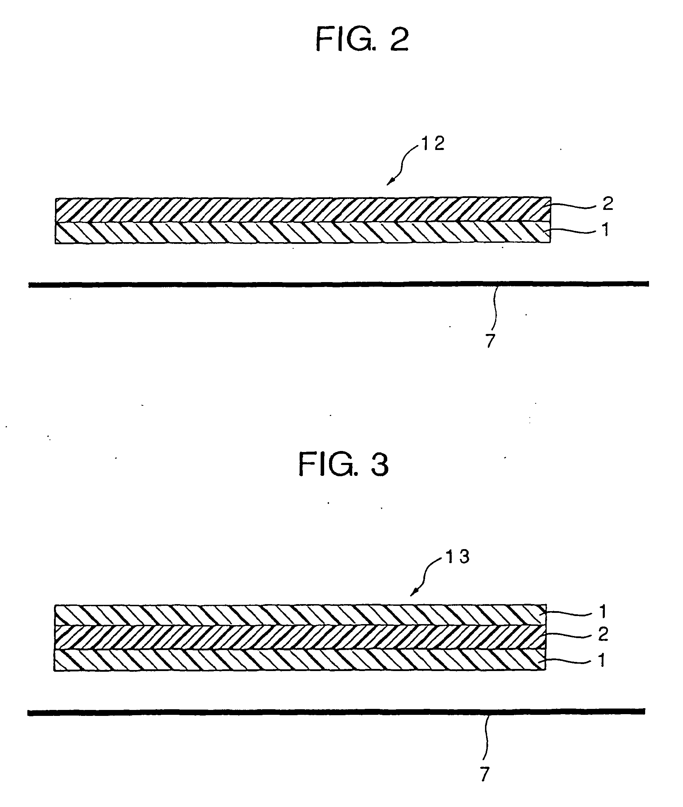

Fig. 2 is a sectional view showing a configuration in which an EMI-suppressing component 12 according to a second embodiment of the present invention is arranged at a position close to a bus line 7. The EMI-suppressing component 12 functioning as a device for suppressing electromagnetic interference has a double layer structure in which the composite magnetic material layer 1 is disposed at a position close to the bus line 7 and the composite permanent magnet layer 2 is disposed on the composite magnetic material layer 1. The composite magnetic material layer 1 and the composite permanent magnet layer 2 are prepared in the same manner as that of the first embodiment. The composite magnetic material layer 1 is arranged at a position close to the line.

Fig. 3 is a sectional view showing a configuration in which an EMI-suppressing component 13 according to a third embodiment of the present invention is arranged at a position close to the bus line 7. In the EMI-suppressing component 13, each composite magnetic material layer 1 is disposed on both faces of the composite permanent magnet layer 2, which functions as a support.

In order to evaluate an EMI-suppressing component of the present invention, a device described below is used.

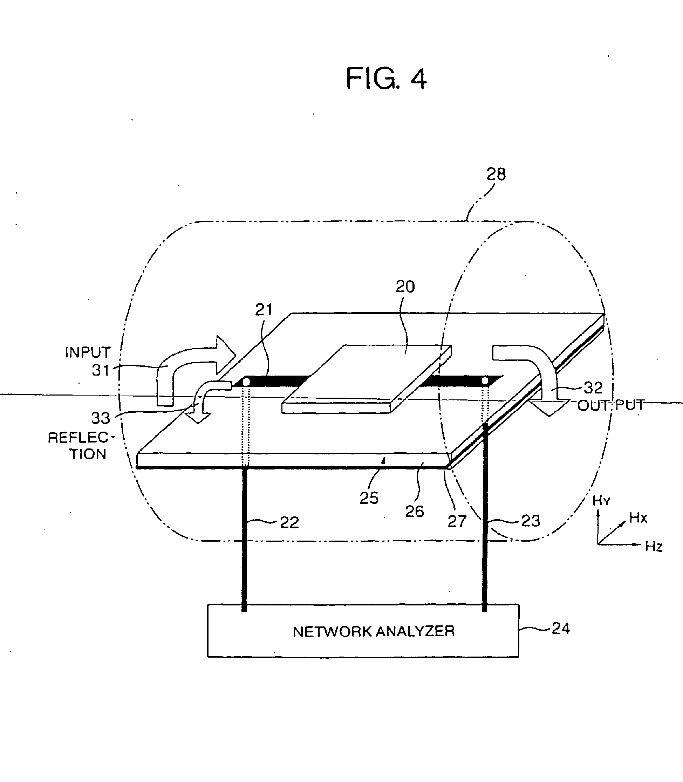

Fig. 4 is an illustration showing a testing apparatus for evaluating an EMI-suppressing component of the present invention. With reference to Fig. 4, a sheet-shaped EMI-suppressing component 20 (that is, a sheet having only a composite magnetic material layer), which is a sample to be measured, is arranged on a micro strip line 21 so as to cover part of this line. The EMI-suppressing component 20 is not equipped with a permanent magnet layer and has length of 20 mm, a width of 20 mm, and a height of 0.5 mm. An adhesive layer 3 is disposed on the composite magnetic material sheet, which is joined to the line 21 with the adhesive layer 3 therebetween. The micro strip line 21 has an input terminal located on an input side 31 and an output terminal located on an output side 32, the input and output terminals are connected to a microanalyzer 24 with leads 22 and 23, respectively. The EMI-suppressing component 20 is placed in Helmholtz coils 28, which are indicated by the two-dotted chain line, such that a bias magnetic field having an intensity of 0-1 kOe (about 0-79.6 kA/m) is applied to the micro strip line 21 in the input/output direction (in the Hz direction).

The transmission characteristics and the electrical loss are obtained by measuring the test sample 20 at a frequency of 1 MHz to 3 GHz.

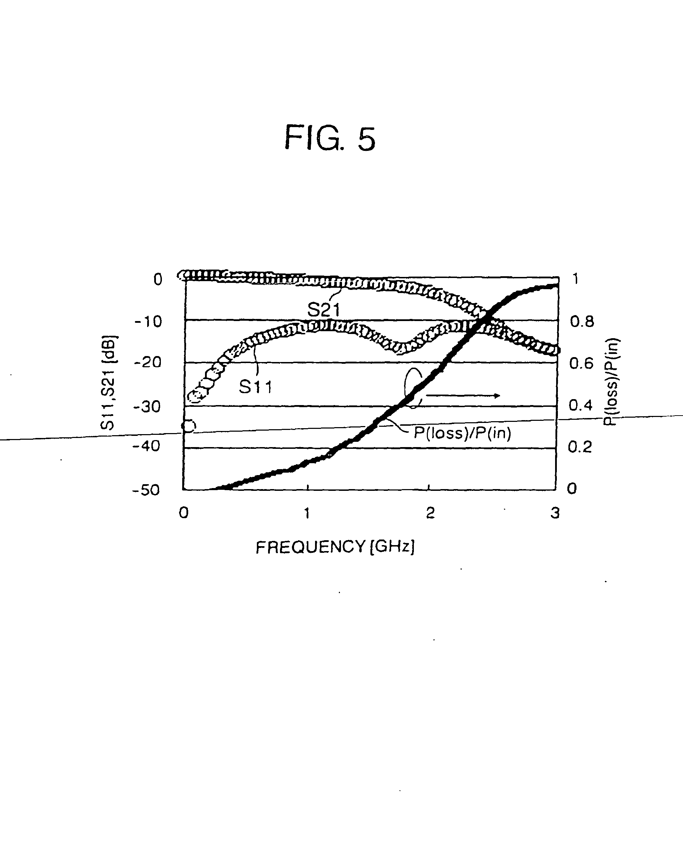

Fig. 5 is a graph showing the reflection/transmission characteristic (S11), the permeation/transmission characteristic (S21), and the electrical loss factor (P(loss) / P(in)) of the sample with respect to frequency at a bias magnetic field intensity of 0, wherein the electrical loss factor corresponds to the ratio of the electrical loss (P(loss)) to the electric power (P(in)), and S11 = 20·log|Γ| (Γ represents the coefficient of reflection) and S21 = 20·log|T| (T represents the coefficient of permeation).

The electrical loss factor corresponds to the amount of electrical power absorbed by the sample. In this sample, it is clear that the electrical loss factor gently increases as the frequency increases.

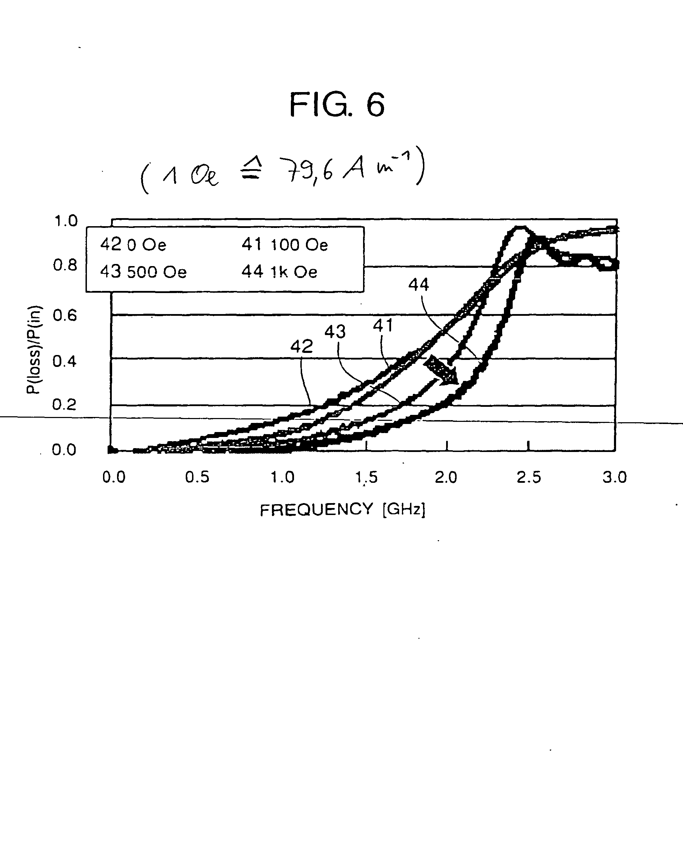

Fig. 6 is a graph showing the electrical loss factor of the sample to which a bias magnetic field is applied. In Fig. 6, the curves 42, 41, 43, and 44 represents the relationship between the electrical loss factor and the frequency when bias magnetic fields having intensities of 0, 100, 500, and 1000 Oe (0, 7.96, 39.5, and 79.6 kA/m, respectively), respectively, are applied in the Hz direction. As shown in the figure, it is clear that each curve sharply rises and has a sharp peak in a high frequency region.

As shown in Table 2, the half-value width decreases as the electrical loss factor increases. The half-value width means the width of a peak at half of the peak height, that is, the frequency band between the high and low frequencies of a peak at half of the peak height in this case.

**[Table 2]**

| H[Oe] | Half-Value Bandwidth [MHz] |
|---|---|
| 0 | 1150 |
| 100 | 900 |
| 500 | 350 |
| 1000 | 250 |

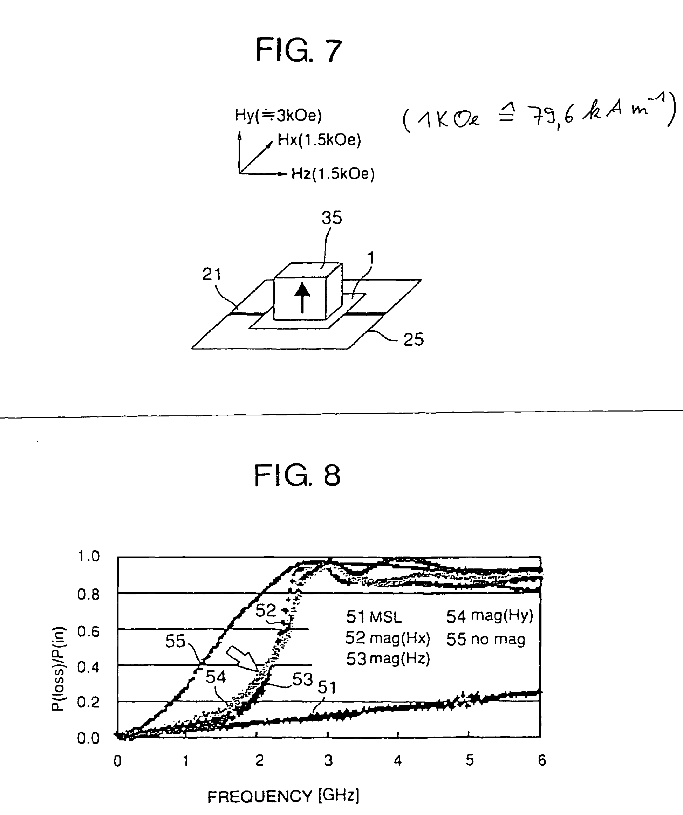

Fig. 7 is an illustration showing a configuration in which a permanent magnet 35 is placed on the sample instead of the Helmholtz coils 28 shown in Fig. 4 for applying a magnetic field. As shown in the figure, the permanent magnet 35 has a volume of 1 cm³ (10⁻⁶ m³) and bias magnetic field intensities Hx, Hy, and Hz of 3 kOe, 1.5 kOe, and 1.5 kOe, respectively (239, 119, and 119 kA/m, respectively) in the Hx, Hy, and Hz directions, respectively.

Fig. 8 is a graph showing the electrical loss factor of the sample shown in Fig. 7, wherein the factor is obtained using the testing apparatus shown in Fig. 4. In the figure, the curve 51 represents the electrical loss factor obtained using only a micro-strip line without using a composite magnetic material and a permanent magnet. The curve 55 represents the electrical loss factor obtained using the composite magnetic material without using the permanent magnet. The curves 52 to 54 represent the electrical loss factor obtained using the composite magnetic material and the permanent magnet with a bias magnetic field applied in the x, z, and y directions, respectively, from the permanent magnet. It is clear that the curves 52, 53, and 54 sharply rise at about 2 GHz, as compared with the curve 55, wherein the intensity Hx is 1.5 kOe (119.4 kA/m), the intensity Hy is 3 kOe (239 kA/m), and the intensity Hz is 1.5 kOe (119 kA/m), in the curves 52, 54, and 53, respectively. In contrast, the curve 51 gently rises.

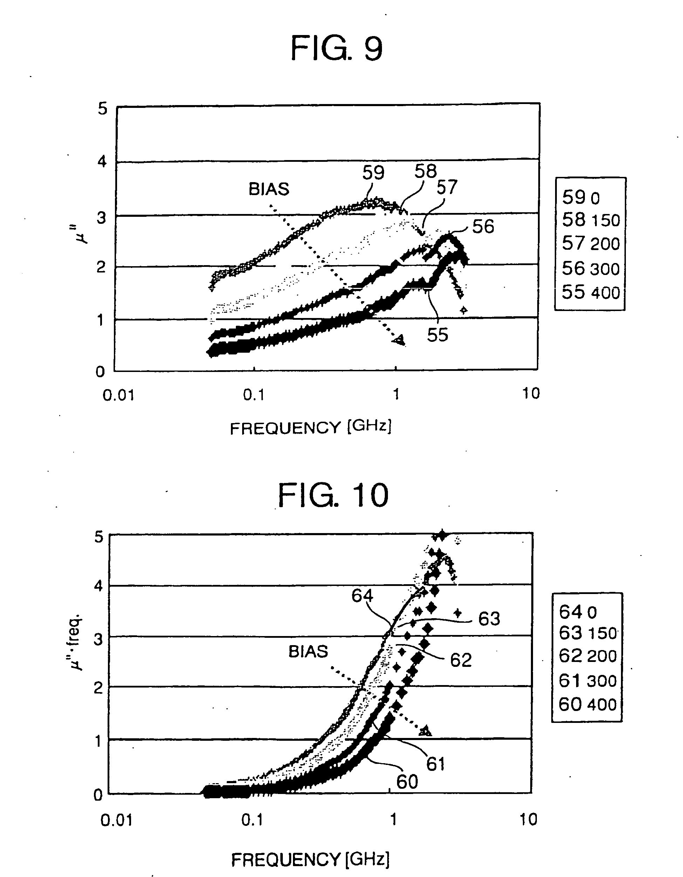

Fig. 9 is a graph showing the relationship between the imaginary part µ' of the permeability and the frequency, and Fig. 10 is a graph showing the relationship between a frequency and a product of the imaginary part µ" of the permeability and the frequency, wherein the permeability is determined by varying the intensity of a bias magnetic field applied to the composite magnetic material in a range of 0-400 Oe. As shown in Fig. 9, it is clear that the imaginary part µ' of the permeability gently increases as the frequency increases and the imaginary part µ' starts to decrease at about 1 GHz as the frequency increases. In contrast, the product of the imaginary part µ" of the permeability and the frequency starts to sharply increase at about 0.5 GHz as the frequency increases.

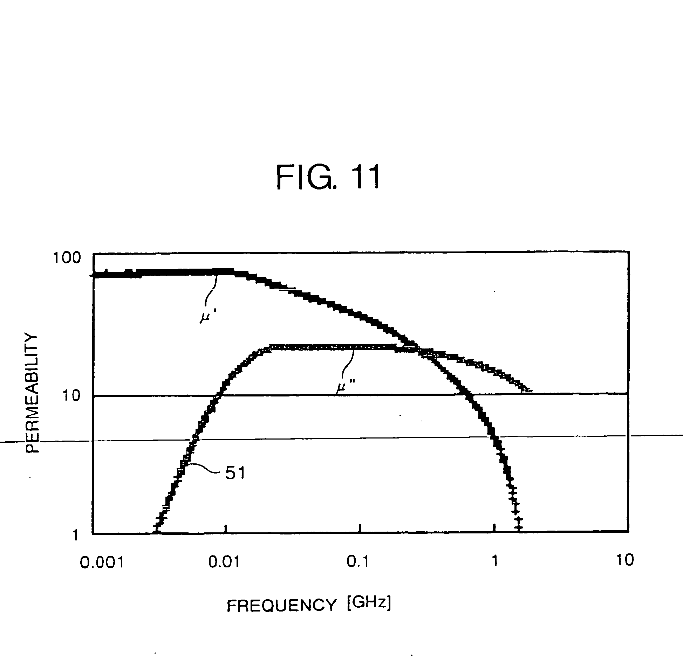

Fig. 11 is a graph showing changes in the real part µ' and the imaginary part µ" of the permeability with respect to the frequency.

From comparisons among Figs. 9, 10, and 11, it is clear that the imaginary part µ", which is a factor effective in suppressing electromagnetic interference, sharply increases and that electromagnetic interference can be effectively suppressed at a particular frequency (for example, 2 GHz or more), by applying a bias magnetic field to the composite magnetic material.

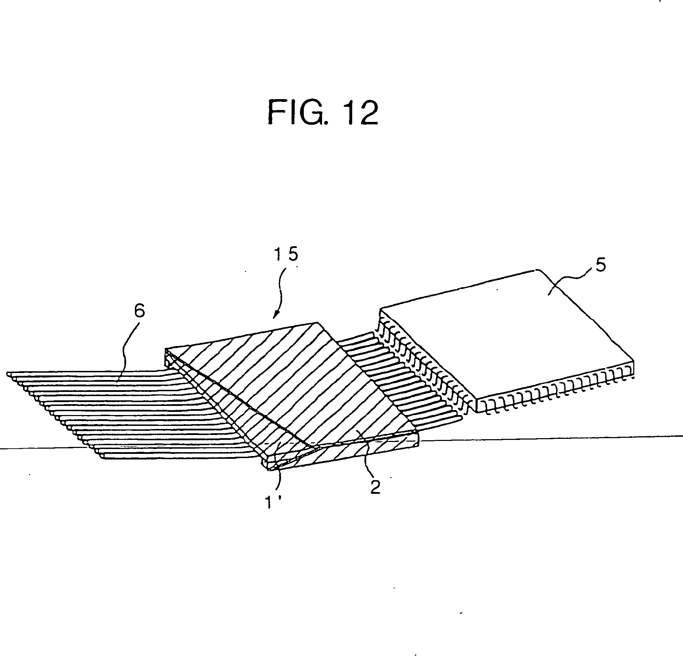

Fig. 12 is a partly exploded perspective view showing a device for illustrating a method of suppressing electromagnetic interference with an EMI-suppressing component according to a fourth embodiment of the present invention. As shown in Fig. 12, in this method, an EMI-suppressing component 15, which is the device for suppressing electromagnetic interference according to the fourth embodiment, is placed on a bus line 6. The electromagnetic interference-suppressing device 15 is equipped with a composite magnetic material body 1' having a substantially C shape. The composite magnetic material body 1' contains an organic binder and magnetic metal powder, including particles each covered with an oxide coating, dispersed in the organic binder. The composite magnetic material body 1' has two magnetic resonance frequencies. The electromagnetic interference-suppressing device 15 has a composite permanent magnet layer 2 on a face of the composite magnetic material body 1'.

Table 3 shows the soft magnetic material powder and the organic binder contained in the composite magnetic material body 1' of the electromagnetic interference-suppressing component 15, wherein the soft magnetic material powder includes a magnetic metal material comprising Fe-Al-Si alloy. In Table 3, the soft magnetic material powder obtained by the oxidation in an oxygen-nitrogen gas atmosphere with an oxygen partial pressure of 20% includes particles each covered with an oxide coating.

In the fourth embodiment of the present invention, the composite magnetic material body 1' can be manufactured by a dry method as described below. The materials shown in Table 3 are heated and mixed, and the mixture is then extruded to form a composite magnetic material extrudate having a thickness of 1 mm and a substantially C shape. The composite magnetic material body 1' has a surface resistance of about 1 × 10⁶ Ω. The composite permanent magnet layer 2 is then formed on the composite magnetic material, wherein the composite permanent magnet layer 2 contains a binder and SmCo₅ permanent magnet powder dispersed in the binder. A bias magnetic field can be supplied to the composite magnetic material body 1' from the composite permanent magnet layer 2 in the same manner as described above, and the same effect as described above can be obtained.

**[Table 3]**

| Soft magnetic powder | | | |
|---|---|---|---|
| Fe-Al-Si alloy | | | 80 weight parts |
| | Average particle diameter: 45µm | | |
| | Aspect ratio: | >5 | |
| | Annealing: | Ar atmosphere 650°C x 2 Hr | |

| Organic binder | | | |
|---|---|---|---|
| ABS resin | | | 20 weight parts |

As described above, according to the present invention, effective measures to suppress EMI can be readily taken for bus lines without reserving a space, which is wasteful. In particular, the present invention provides an EMI-suppressing component and an EMI-suppressing method, wherein the EMI-suppressing component and method can be used at the high frequencies recently used for signals and can reduce radiated noise without causing secondary radiation at high frequencies and over a wide band.

Furthermore, the present invention provides such an EMI-suppressing component and method that are effective in reducing the size and cost of electronic devices and have the following many advantages: there is no need to take measures in advance, less time is required and there is no need of expertise in order to take measures, there is no need to reserve a particular space, and the component is inexpensive as compared with filters.

### Industrial Applicability:

As described above, an EMI-suppressing component and method according to the present invention are extremely effective in suppressing electromagnetic interference caused by electromagnetic noise of electronic devices and electrical equipment.

## Claims

1. A component (11) for suppressing EMI comprising a composite magnetic material layer (1) and a composite permanent magnet layer (2) disposed on at least part of the composite magnetic material layer (1) wherein the composite magnetic material layer (1) contains an organic binder and a metal soft magnetic powder dispersed in the organic binder, the composite permanent magnet layer (2) contains a binder and a permanent magnet powder dispersed in the binder, and a bias magnetic field is applied to the composite magnetic material layer (1) from the composite permanent magnet layer (2).

2. The component for suppressing EMI according to Claim 1, wherein the component (11) covers part of a bus line (6) for information-processing equipment.

3. The component for suppressing EMI according to Claim 1, wherein the permanent magnet powder is a Sm-Co permanent magnetic one.

4. The component for suppressing EMI according to Claim 1, wherein the metal soft magnetic powder includes magnetic metal particles having an oxide coating and the composite magnetic material layer has a surface resistance of at least 10³ Ω.

5. The component for suppressing EMI according to any one Claims 1 to 4, wherein the composite magnetic material layer has at least two different magnetic resonance frequencies resulting from anisotropic magnetic fields having different intensities.

6. The component for suppressing EMI according to any one of Claims 1 to 5, wherein the composite magnetic material layer has an adhesive layer (3) containing, as a main component, one selected from the group consisting of gum, dextrin, and polyvinyl alcohol.

7. The component for suppressing EMI according to any one of Claims 1 to 6, wherein the composite magnetic material layer (1) is sheet-shaped.

8. The component for suppressing EMI according to any one of Claims 1 to 7, wherein the composite magnetic material layer (1) is a formed body having a substantially C shape.

9. The component for suppressing EMI according to Claim 8, wherein the composite magnetic material layer (1) is covered with the composite permanent magnet layer (2).

10. A method of suppressing EMI comprising the steps of:
covering part of a bus line (6) of information-processing equipment (5) with a composite magnetic material layer (1) containing an organic binder and a metal soft magnetic powder dispersed in the organic binder; and
applying a bias magnetic field to the composite magnetic material layer.

11. The method EMI according to Claim 10, wherein the bias magnetic field is supplied from a composite permanent magnet layer (2) that is disposed on part of the composite magnetic material layer (1) and contains a binder and a permanent magnet powder dispersed in the binder.

12. The method according to Claim 11, wherein the permanent magnet powder includes SmCo particles.

13. The method according to Claim 10, wherein the metal soft magnetic powder includes magnetic metal particles having an oxide coating and the composite magnetic material layer has a surface resistance of at least 10³ Ω.

14. The method according to any one of Claims 10 to 13, wherein the composite magnetic material layer (1) has at least two magnetic resonance frequencies resulting from anisotropic magnetic fields having different intensities.

15. The method according to any one of Claims 10 to 14, wherein the composite magnetic material layer (1) has an adhesive layer (3) containing, as a main component, one selected from the group consisting of gum, dextrin, and polyvinyl alcohol.

16. The method according to Claims 11, wherein the composite magnetic material layer (1) and the composite permanent magnet layer (2) are multilayer sheets.

17. The method for suppressing EMI according to any one of Claims 10 to 16, wherein the composite magnetic material layer (1) is a formed body having a substantially C shape.

18. The method according to Claims 17, wherein the composite magnetic material layer (1) is covered with the composite permanent magnet layer (2).

## Patentansprüche

1. Komponente (11) zum Unterdrücken von EMI mit einer zusammengesetzten Magnetmaterialschicht (1) und einer zusammengesetzten Permanentmagnetschicht (2), die auf mindestens einen Teil der zusammengesetzten Magnetmaterialschicht (1) vorgesehen ist,
worin die zusammengesetzte Magnetmaterialschicht (1) einen organischen Binder und ein Metallweichmagnetpulver enthält, das in dem organischen Binder verteilt ist,
die zusammengesetzte Permanentmagnetschicht (2) einen Binder und ein Permanentmagnetpulver enthält, das in dem Binder verteilt ist, und
ein Vorspannungsmagnetfeld an die zusammengesetzte Magnetmaterialschicht (1) von der zusammengesetzten Permanentmagnetschicht (2) angelegt ist.

2. Komponente zum Unterdrücken von EMI nach Anspruch 1, bei der die Komponente (11) einen Teil einer Busleitung (6) für eine Informationsverarbeitungsausrüstung bedeckt.

3. Komponente zum Unterdrücken von EMI nach Anspruch 1, bei der das Permanentmagnetpulver eines ist vom Sm-Co-Permanentmagnettyp.

4. Komponente zum Unterdrücken von EMI nach Anspruch 1, bei der das Metallweichmagnetpulver Magnetmetallteilchen mit einer Oxidbeschichtung enthält und die zusammengesetzte Magnetmaterialschicht einen Oberflächenwiderstand von mindestens 10³Ω aufweist.

5. Komponente zum Unterdrücken von EMI nach einem der Ansprüche 1 bis 4, bei der die zusammengesetzte Magnetmaterialschicht mindestens zwei verschiedene Magnetresonanzfrequenzen aufweist, die von anisotropen Magnetfeldern mit verschiedenen Intensitäten herrühren.

6. Komponente zum Unterdrücken von EMI nach einem der Ansprüche 1 bis 5, bei der die zusammengesetzte Magnetmaterialschicht eine Klebeschicht (3) aufweist, die als Hauptkomponente eine enthält, die aus der Gruppe gewählt ist, die aus Gummi, Dextrin und Polyvinylalkohol besteht.

7. Komponente zum Unterdrücken von EMI nach einem der Ansprüche 1 bis 6, bei der die zusammengesetzte Magnetmaterialschicht (1) plattenförmig ist.

8. Komponente zum Unterdrücken von EMI nach einem der Ansprüche 1 bis 7, bei der die zusammengesetzte Magnetmaterialschicht (1) als ein Körper mit einer im wesentlichen C-Form gebildet ist.

9. Komponente zum Unterdrücken von EMI nach Anspruch 8, bei der die zusammengesetzte Magnetmaterialschicht (1) mit der zusammengesetzten Permanentmagnetschicht (2) bedeckt ist.

10. Verfahren zum Unterdrücken von EMI mit den Schritten:
Bedecken eines Teiles einer Busleitung (6) einer Informationsverarbeitungsausrüstung (5) mit einer zusammengesetzten Magnetmaterialschicht (1), die einen organischen Binder und ein Metallweichmagnetpulver enthält, das in dem Binder verteilt wird; und
Anlegen eines Vorspannungsmagnetfeldes an die zusammengesetzte Magnetmaterialschicht.

11. Verfahren nach Anspruch 10, bei dem das Vorspannungsmagnetfeld von einer zusammengesetzten Permanentmagnetschicht (2) geliefert wird, die auf einem Teil der zusammengesetzten Magnetmaterialschicht (1) vorgesehen ist und einen Binder und ein Permanentmagnetpulver enthält, das in dem Binder verteilt ist.

12. Verfahren nach Anspruch 11, bei dem das Permanentmagnetpulver SmCo-Teilchen enthält.

13. Verfahren nach Anspruch 10, bei das Metallweichmagnetpulver magnetische Metallteilchen enthält mit einer Oxidbeschichtung und die zusammengesetzte Magnetmaterialschicht einen Oberflächenwiderstand von mindestens 10³Ω aufweist.

14. Verfahren nach einem der Ansprüche 10 bis 13, bei dem die zusammengesetzte Magnetmaterialschicht (1) mindestens zwei Magnetresonanzfrequenzen aufweist, die von anisotropen Magnetfeldern mit verschiedenen Intensitäten herrühren.

15. Verfahren nach einem der Ansprüche 10 bis 14, bei denen die zusammengesetzte Magnetmaterialschicht (1) eine Klebeschicht (3) aufweist, die als eine Hauptkomponente eine enthält, die aus der Gruppe gewählt wird, die aus Gummi, Dextrin und Polyvinylalkohol besteht.

16. Verfahren nach Anspruch 11, bei dem die zusammengesetzte Magnetmaterialschicht (1) und die zusammengesetzte Permanentmagnetschicht (2) Mehrschichtplatten sind.

17. Verfahren zum Unterdrücken von EMI nach einem der Ansprüche 10 bis 16, bei dem die zusammengesetzte Magnetmaterialschicht (1) als ein Körper mit einer im wesentlichen C-Form gebildet wird.

18. Verfahren nach Anspruch 17, bei dem die zusammengesetzte Magnetmaterialschicht (1) mit der zusammengesetzten Permanentmagnetschicht (2) bedeckt wird.

## Revendications

1. Composant (11) supprimant les parasites électromagnétiques, comprenant une couche de matériau magnétique composite (1) et une couche constituée d'un aimant permanent composite (2) disposée sur au moins une partie de la couche de matériau magnétique composite (1),
dans lequel
la couche de matériau magnétique composite (1) contient un liant organique et une poudre métallique magnétique douce, dispersée dans le liant organique, la couche constituée d'un aimant permanent composite (2) contient un liant et une poudre magnétique permanente dispersée dans le liant, et un champ magnétique polarisé est appliqué à la couche de matériau magnétique composite (1) par la couche constituée d'un aimant permanent composite (2).

2. Composant supprimant les parasites électromagnétiques selon la revendication 1,
dans lequel le composant (11) recouvre une partie d'une ligne de bus (6) pour du matériel de traitement des informations.

3. Composant supprimant les parasites électromagnétiques selon la revendication 1,
dans lequel la poudre magnétique permanente est une poudre magnétique permanente en Sm-Co.

4. Composant supprimant les parasites électromagnétiques selon la revendication 1,
dans lequel la poudre métallique magnétique douce inclut des particules métalliques magnétiques ayant un enrobage en oxyde et la couche de matériau magnétique composite a une résistance en surface d'au moins 10³ Ω.

5. Composant supprimant les parasites électromagnétiques selon l'une quelconque des revendications 1 à 4,
dans lequel la couche de matériau magnétique composite a au moins deux différentes fréquences de résonance magnétique résultant de champs magnétiques anisotropiques ayant des intensités différentes.

6. Composant supprimant les parasites électromagnétiques selon l'une quelconque des revendications 1 à 5,
dans lequel la couche de matériau magnétique composite comporte une couche adhésive (3) contenant, comme principal composant, un composant choisi dans le groupe constitué par la gomme, la dextrine et l'alcool polyvinylique.

7. Composant supprimant les parasites électromagnétiques selon l'une quelconque des revendications 1 à 6,
dans lequel la couche de matériau magnétique composite (1) est en forme de feuille.

8. Composant supprimant les parasites électromagnétiques selon l'une quelconque des revendications 1 à 7,
dans lequel la couche de matériau magnétique composite (1) est un corps formé ayant une forme sensiblement en C.

9. Composant supprimant les parasites électromagnétiques selon la revendication 8,
dans lequel la couche de matériau magnétique composite (1) est recouverte de la couche constituée d'un aimant permanent composite (2).

10. Procédé de suppression des parasites électromagnétiques comprenant les étapes consistant à :
- recouvrir en partie une ligne de bus (6) de matériel de traitement des informations (5) d'une couche de matériau magnétique composite (1) contenant un liant organique et une poudre métallique magnétique douce dispersée dans le liant organique, et
- appliquer un champ magnétique polarisé à la couche de matériau magnétique composite.

11. Procédé de suppression des parasites électromagnétiques selon la revendication 10,
selon lequel le champ magnétique polarisé est fourni par une couche constituée d'un aimant permanent composite (2) disposée sur une partie de la couche de matériau magnétique composite (1) et contenant un liant ainsi qu'une poudre magnétique permanente dispersée dans le liant.

12. Procédé selon la revendication 11,
selon lequel la poudre magnétique permanente inclut des particules de SmCo.

13. Procédé selon la revendication 10,
selon lequel la poudre métallique magnétique douce inclut des particules métalliques magnétiques ayant un enrobage en oxyde et la couche de matériau magnétique composite a une résistance en surface d'au moins 10³ Ω.

14. Procédé selon l'une quelconque des revendications 10 à 13,
selon lequel la couche de matériau magnétique composite (1) a au moins deux fréquences de résonance magnétique résultant de champs magnétiques anisotropiques ayant des intensités différentes.

15. Procédé selon l'une quelconque des revendications 10 à 14,
selon lequel la couche de matériau magnétique composite (1) comporte une couche adhésive (3) contenant, comme principal composant, un composant choisi dans le groupe constitué par la gomme, la dextrine et l'alcool polyvinylique.

16. Procédé selon la revendication 11,
selon lequel la couche de matériau magnétique composite (1) et la couche constituée d'un aimant permanent composite (2) sont des feuilles multicouches.

17. Procédé de suppression des parasites électromagnétiques
selon l'une quelconque des revendications 10 à 16,
selon lequel la couche de matériau magnétique composite (1) est un corps formé ayant une forme sensiblement en C.

18. Procédé selon la revendication 17,
selon lequel la couche de matériau magnétique composite (1) est recouverte de la couche constituée d'un aimant permanent composite (2).
